# FASCICULE DE BREVET EUROPEEN

(11) **EP 1 243 029 B1**
(45) Date de publication et mention de la délivrance du brevet: **10.10.2007**
(21) Numéro de dépôt: 00988939.5
(22) Date de dépôt: 15.12.2000
(51) Int. Cl.: H01L 29/737, H01L 21/331

(54) **Transistor bipolaire à hétérojonction collecteur en haut et procédé de réalisation**
Heteroübergang-Bipolartransistor mit obenliegendem Kollektor und dessen Herstellungsverfahren
Bipolar transistor with upper heterojunction collector and method for making the same

(30) Priorité: 23.12.1999 FR 9916400
(43) Date de publication de la demande: 25.09.2002
(73) Titulaire: Thales, 75008 Paris (FR)
(72) Inventeur: DELAGE, Sylvain, Thales Intellectual Property, F-94117 Arcueil Cedex (FR); CASSETTE, Simone, Thales Intellectual Property, F-94117 Arcueil Cedex (FR); FLORIOT, Didier, Thales Intellectual Property, F-94117 Arcueil Cedex (FR); GIRARDOT, Arnaud,Thales Intellectual Property, F-94117 Arcueil Cedex (FR)
(86) Numéro de dépôt international: PCT/FR2000/003562
(87) Numéro de publication internationale: WO 2001/048829

(56) Documents cités:
- EP-A- 0 240 307
- EP-A- 0 300 803
- EP-A- 0 562 272
- FR-A- 2 697 945
- FR-A- 2 737 342
- FR-A- 2 764 118
- PATENT ABSTRACTS OF JAPAN vol. 1995, no. 08, 29 septembre 1995 (1995-09-29) & JP 07 122573 A (NIPPON TELEGR & TELEPH CORP), 12 mai 1995 (1995-05-12)

## Description

L'invention concerne un transistor bipolaire à hétérojonction à collecteur en haut et son procédé de réalisation.

L'invention vise à l'amélioration du transport électronique dans les transistors bipolaires à hétérojonction (TBH) en topologie Collecteur en haut (Collector-up), tout en assurant un rendement de fabrication élevé.

La configuration Collecteur en haut est particulièrement intéressante dans le cas d'un transistor bipolaire à hétérojonction du fait des faibles valeurs de capacité base-collecteur qu'elle permet d'obtenir en comparaison à celles que l'on retrouve avec une topologie classique dite émetteur en haut. La réduction de cette capacité de jonction permet d'améliorer notablement les performances hyperfréquences de ce type de composant.

En revanche, si l'on ne prend pas quelques précautions particulières, apparaît dans un TBH Collecteur en haut une injection parasite d'électrons dans les zones de base extrinsèque. Ces électrons sont alors collectés par les contacts de base ou se recombinent dans la base extrinsèque ; ce qui, dans les deux cas, aboutit à une dégradation du facteur de transport dans la base et donc pénalise fortement le gain en courant du transistor. Certaines solutions ont déjà été apportées à ce problème et notamment dans le cadre des TBH Collecteur en haut élaborés avec des matériaux GaAlAs/GaAs ou GalnP/GaAs.

Ainsi Yamahata et al. décrit dans une publication (IEEE Electron Device Letters, Vol.14, n°4, Avril 1993) un transistor bipolaire à simple hétérojonction (S-TBH) Collecteur en haut GaAlAs/GaAs où la zone d'émetteur située en dessous de la base extrinsèque est transformée en une couche hautement résistive par implantation ionique. Il s'affranchit, de cette manière, de l'injection parasite d'électrons que nous avons mentionnée précédemment et par la même, améliore le gain en courant du TBH ainsi réalisé.

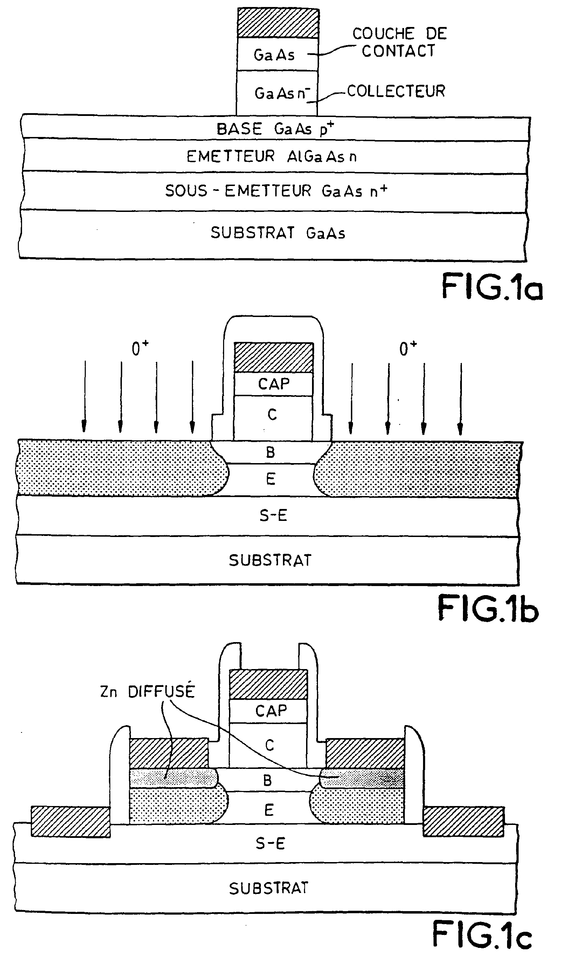

La figure 1 montre le procédé de fabrication utilisé par Yamahata et al.. En premier lieu, un contact métallique de collecteur est déposé sur la structure épitaxiale. Il est utilisé comme masque pour la gravure de la couche de collecteur (Fig.1a). La structure est alors implantée aux ions Oxygène à travers la base avec une énergie déterminée pour rendre électriquement isolantes les zones d'émetteur extrinsèque (Fig.1b). Une diffusion de Zinc permet de rétablir un niveau suffisant de dopage p' de la couche de base endommagée lors de l'implantation ionique (Fig.1c). Les contacts métalliques de base sont alors déposés. Les couches de base et d'émetteur sont ensuite gravées pour déposer sur un sous-émetteur dopé n⁺ des contacts métalliques d'émetteur. Le composant ainsi réalisé présente une faible capacité base-collecteur et une base fortement dopée.

Un tel procédé de fabrication présente certains inconvénients. Tout d'abord, la base est sévèrement endommagée lors de l'étape d'implantation ionique Oxygène. En effet, la plaque étant désorientée de 7° par rapport à la direction du faisceau d'implantation, elle est donc vue par ce dernier dans un état quasi-amorphe. Le nombre de défauts cristallins générés dans la base est donc maximum. La diffusion de Zinc permet de masquer en partie cette dégradation mais ne permet pas de retrouver la conductivité initiale de la base. De plus, lors des étapes d'implantation et de diffusion, les flancs de la mésa de collecteur doivent être protégés par un nitrure ce qui induit une étape de lithographie et de process supplémentaire. Avec ce procédé, la surface de la zone active intrinsèque est définie, donc limitée, par la taille du collecteur. Il est à noter que, du fait de la diffusion élevée du Zinc, il existe un risque important de voir apparaître, à la jonction base-émetteur, des court-circuits ayant un impact déplorable sur la fiabilité des composants.

Le Laboratoire Centre de Recherche de THOMSON-CSF a abouti à la réalisation de transistors bipolaires à hétérojonction (D-TBH) GaInP/GaAs en topologie collecteur en haut tel que cela est décrit dans l'article de HENKEL et al IEE Electronics Letters, Vol. 33, n° 7, Mars 1997. La zone d'émetteur située en-dessous de la base extrinsèque est là aussi transformée en une couche hautement résistive mais par une implantation ionique optimisée en vue de conserver à la base de sa conductivité initiale.

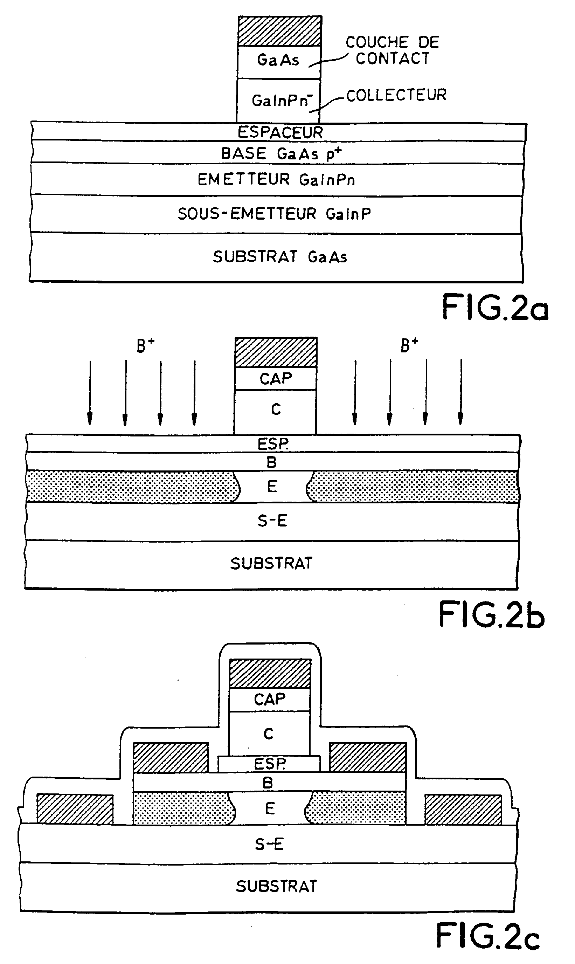

La figure 2 montre le procédé de fabrication utilisé. Un contact métallique de collecteur est, tout d'abord, déposé sur la structure épitaxiale. Il est utilisé comme masque pour la gravure de la couche de collecteur (Fig.2a). La structure est alors implantée aux ions Bore à travers la base et à faible dose (Fig.2b). L'angle d'implantation est de 0° de manière à minimiser les collisions des ions Bore avec le réseau cristallin de la base. Les contacts métalliques de base sont alors déposés. Les couches de base et d'émetteur sont ensuite gravées pour déposer sur un sous-émetteur dopé n⁺ des contacts métalliques d'émetteur (Fig.2c). Ces derniers subissent alors un recuit (416°C pendant 10mn par exemple) permettant la formation d'un alliage à l'interface métal/semiconducteur. Il est important de remarquer que la résistivité de la base, qui augmente légèrement lors de l'étape d'implantation ionique, décroît et revient à l'issue de ce recuit à sa valeur initiale.

Ce procédé de fabrication, basé sur la sensibilité différente de la conductivité de matériaux semiconducteurs différents soumis à une même implantation ionique, permet d'isoler électriquement, et ce, très efficacement, les zones d'émetteur extrinsèque tout en maintenant la conductivité de la couche de base à une valeur proche de sa valeur initiale. Cette dernière propriété est, d'une part, liée au fait que l'implantation se fait à faible dose. Le nombre de défauts cristallins générés dans la base est donc minimisé. D'autre part, la plaque n'est plus désorientée par rapport à la direction du faisceau d'implantation (angle d'implantation nul), les ions implantés sont alors canalisés dans le réseau cristallin. Les possibilités de collision d'une particule de Bore incidente avec les atomes et les électrons constituants le matériau de base sont alors réduites. Il en est donc de même pour le nombre de défauts cristallins générés dans la base. De plus, l'étape de diffusion de Zinc proposée par Yamahata et al. est alors inutile d'où une simplification du procédé de fabrication.

Ce procédé de fabrication particulièrement avantageux présente malheureusement certaines limitations. En effet, si les performances hyperfréquences de ce type de composants sont particulièrement intéressantes (Fₘₐₓ=115GHz), la valeur du gain statique en courant obtenue est faible. Pour analyser ce comportement, il nous faut rappeler les résultats des travaux de Horio et al. publiés dans IEEE Transactions on Electron Devices, Vol.42, n°11, Novembre 1995.

Les travaux de HORIO et al portent sur des dispositifs TBH Emetteur en haut élaborés avec des matériaux GaAlAs/GaAs. Ces travaux ont mis en exergue une accumulation des électrons dans les régions de base extrinsèque dans le cas où le TBH Emetteur en haut présente un collecteur extrinsèque rendu parfaitement isolant et une surface de la jonction base-collecteur légèrement inférieure à celle de la jonction émetteur-base. De cette accumulation résultent, d'une part, une dégradation de la fréquence de coupure du gain en courant fₜ, et d'autre part, une recombinaison des porteurs dans la base qui va fortement pénaliser le gain statique du transistor. Dans le cas d'une structure similaire mais présentant un collecteur extrinsèque semi-isolant (ce qui correspond à un collecteur extrinsèque électriquement isolé par implantation ionique), le phénomène d'accumulation des électrons semble beaucoup plus limité et donc les dégradations du gain en courant et de fₜ, beaucoup plus faibles. De plus, Horio constate que les performances du composant sont optimales lorsque la surface de la jonction émetteur-base est légèrement inférieure à celle de la jonction base-collecteur et ce, quelle que soit la nature du collecteur extrinsèque (isolant ou semi-isolant).

Malheureusement, la topologie Collecteur en haut revient à se placer dans le plus défavorable des deux cas précédents. En effet, dans cette structure, la surface du collecteur à la jonction base-collecteur définit la zone active du composant. Les zones de collecteur extrinsèque sont donc inexistantes et peuvent être modélisées par un isolant parfait. Dans cette configuration, si la surface de la jonction base-collecteur est inférieure à celle de la jonction émetteur-base, le phénomène d'accumulation des électrons dans les régions de base extrinsèque est particulièrement important. Et de même que pour la topologie Emetteur en haut, les performances optimales sont obtenues lorsque la surface de la jonction émetteur-base est la plus petite des deux. La réalisation de composants Collecteur en haut performants exige donc une parfaite maîtrise des techniques d'implantation et de gravure qui vont aboutir à la définition des surfaces des deux jonctions.

Dans le cas de transistors bipolaires à hétérojonction en topologie Collecteur en haut, la gravure de la mésa de collecteur repose sur la sélectivité de gravure entre les deux matériaux constituant collecteur et base (cas du D-TBH) ou couche d'arrêt de gravure et base (cas du S-TBH). Le contact métallique de collecteur est utilisé comme masque pour la gravure du collecteur. La surface de ce contact définit donc celle de la jonction base-collecteur à la sous-gravure près (si elle existe).

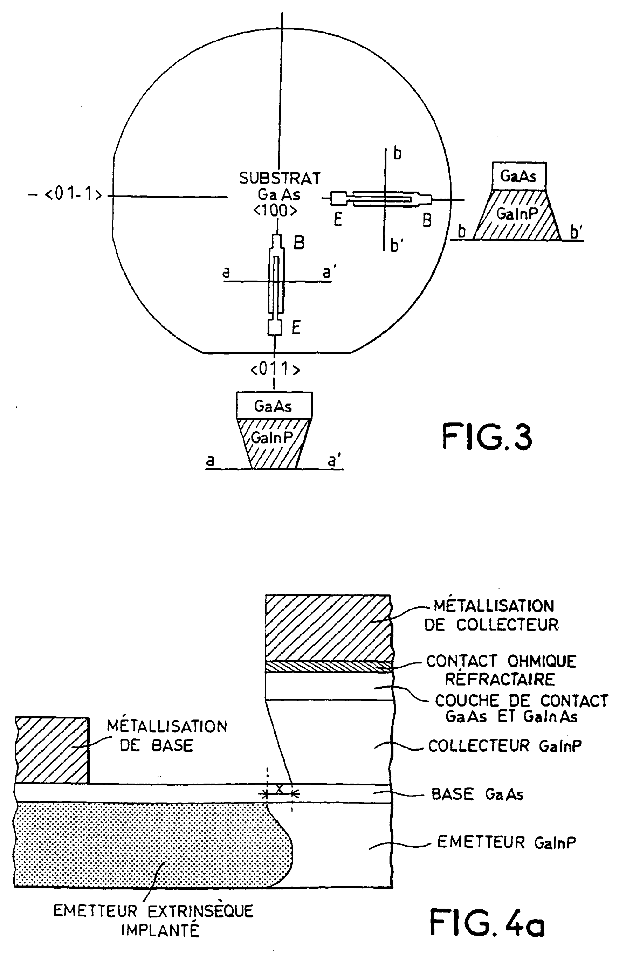

La figure 3 montre le profil de gravure que l'on obtient selon l'orientation cristalline pour un collecteur en GaInP (cas du D-TBH). Ce profil est classiquement obtenu par gravure chimique (par exemple à l'aide d'acide chlorhydrique dilué ou non). On remarque que, selon l'orientation cristalline, un angle rentrant ou sortant est observé. L'exemple est pris dans le cas d'un substrat GaAs (100) orienté selon la norme Européenne-Japonaise de repérages des plaquettes. La forme indiquée est très simplement obtenue sous la condition que la couche de GaInP soit suffisamment fine (de l'ordre de 0,5 µm). On notera que la gravure du GainP se bloque à l'interface GaAs/GalnP ce qui rend la fabrication plus aisée (voir brevet français n° 2 697 945). La couche de GaAs fixe ainsi la dimension latérale du dispositif. Une fois la structure implantée au bore, la surface de la jonction émetteur-base est définie par la forme des caissons d'isolation créés dans la zone d'émetteur extrinsèque. Comme on a pu le voir précédemment le contact métallique de collecteur sert de masque d'implantation mais la forme de ces caissons va dépendre aussi du profil des flancs de la mésa collecteur.

Ainsi pour un D-TBH dont le doigt de collecteur est orienté selon la direction cristallographique <0 1 1>, les flancs de la mésa collecteur sont rentrants (Fig. 4a). Si l'on définit x comme la différence entre la largeur du collecteur extrinsèque (définie par la gravure) et celle de l'émetteur extrinsèque (définie par la forme des caissons d'isolation), x est alors négatif et de l'ordre de -0,2µm. La jonction émetteur-base présente donc une surface supérieure à celle de la jonction base-collecteur et x est suffisamment important pour entraîner une forte dégradation du gain en courant et de fₜ.

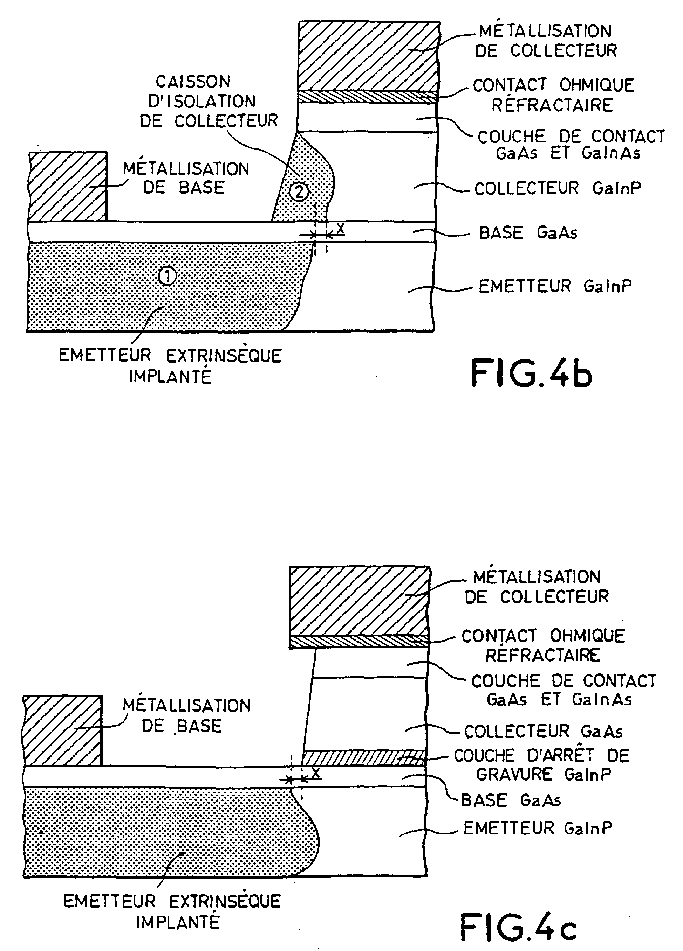

Si l'électrode de collecteur du D-TBH est orientée selon la direction cristallographique <0 1 -1>, le profil de gravure est alors sortant. Les flancs de la mésa collecteur, non protégés par la métallisation de collecteur, sont alors exposés à l'implantation ionique au Bore. Il y a donc apparitions de caissons d'isolation dans l'émetteur ① mais aussi dans le collecteur ② (Fig. 4b). La largeur du collecteur extrinsèque n'est non plus définie par gravure mais par la forme des caissons d'isolation de collecteur. x est alors négatif mais faible en valeur absolue. La dégradation du gain en courant et de fₜ est alors moins importante que dans le cas précédent mais cependant toujours présente.

La gravure d'un collecteur en GaAs (cas du S-TBH) s'effectue en deux opérations : une gravure ionique réactive (telle que SiCl₄) suivie d'une gravure chimique (à l'acide citrique par exemple). En effet, de manière à ne pas endommager le matériau de base, on peut profiter de l'existence de la très grande sélectivité de gravure entre une couche à base de phosphore et une couche à base d'arsenic. Une couche d'arrêt de gravure de faible épaisseur est donc rajoutée entre le collecteur (GaAs n) et la base (GaAs p⁺). Faite par exemple de GalnP, elle permet de stopper la gravure du collecteur en GaAs. Une gravure chimique de la couche d'arrêt est ensuite réalisée à l'aide d'une solution qui peut être à base, par exemple, d'acide chlorhydrique dilué. A l'issue de cette séquence, le profil obtenu ne dépend pas de l'orientation cristalline et présente un angle sortant associé à une sous-gravure à l'interface avec le contact ohmique (Fig. 4c). La largeur du collecteur extrinsèque est donc définie par les flancs de gravure et x est, là encore, négatif mais faible en valeur absolue. La dégradation du gain en courant et de fₜ est sensiblement la même que dans le cas précédent.

Ainsi des solutions ont été apportées pour s'affranchir de l'injection parasite d'électrons dans la base extrinsèque qui constitue la difficulté la plus importante lors de la réalisation de TBH Collecteur en haut. Parmi celles-ci, la réalisation de caissons d'isolation dans l'émetteur extrinsèque par une implantation ionique à faible dose à travers la base permet en outre de conserver à cette dernière sa conductivité initiale. Mais comme nous avons pu le constater, il n'est pas possible dans le cas de la fabrication de TBH Collecteur en haut constitués de composés Ga_{X}In₁₋ₓAs/Ga_{Y}In_{1-Y}P de définir les surfaces des jonctions émetteur-base et base-collecteur de manière à obtenir les performances optimales susceptibles d'être atteintes avec de telles structures. La présente invention vise à atteindre ces performances en optimisant la collection des porteurs minoritaires à la sortie de la base c'est à dire en s'affranchissant de l'accumulation d'électrons dans les régions de base extrinsèque. Il faut pour cela réussir à définir une jonction base-collecteur dont la surface soit plus importante que celle de la jonction émetteur-base, et que le collecteur extrinsèque, s'il existe, soit fait d'un matériau semi-isolant.

L'invention concerne donc un transistor bipolaire à hétérojonction à collecteur en haut comprenant notamment empilées sur un substrat :
- une couche d'émetteur
- une couche de base
- une couche de collecteur
- le matériau de la couche de base présente une sensibilité de la conductivité électrique en fonction de la dose d'ions introduits lors d'une implantation ionique plus faible que la sensibilité de la conductivité électrique du matériau de la couche d'émetteur en fonction de la dose d'ions introduits lors de la même implantation ionique;
caractérisé en ce que:
- la surface de la jonction active base-émetteur est de dimensions inférieures à la surface de la jonction active base-collecteur.

L'invention concerne également un procédé de réalisation d'un transistor bipolaire à hétérojonction à collecteur en haut comme défini dessus comprenant notamment la croissance épitaxiale de couches semiconductrices sur un substrat semiconducteur :
- une couche d'émetteur
- une couche de base
- une couche de collecteur
caractérisé en ce que :
- les matériaux de la couche de base et de la couche d'émetteur sont choisis tels que le matériau de la couche de base présente une sensibilité de la conductivité électrique en fonction de la dose d'ions introduits lors d'une implantation ionique plus faible que la sensibilité de la conductivité électrique de la couche d'émetteur en fonction de la dose d'ions introduits lors de la même implantation ionique ;
- et en ce qu'il comporte les étapes supplémentaires suivantes : réalisation d'un masque sur la couche de collecteur et de largeur (Ic) définissant la largeur du collecteur à obtenir, puis réalisation d'une première implantation ionique permettant de rendre isolant le matériau de la couche d'émetteur de part et d'autre de l'émetteur à obtenir, puis réalisation d'une deuxième implantation ionique faite à une ou plusieurs énergies inférieures à la première implantation ionique pour rendre isolant le matériau de la couche de collecteur de part et d'autre du collecteur à obtenir.

Les différents objets et caractéristiques de l'invention apparaîtront plus clairement dans la description qui va suivre faite à titre d'exemple ainsi que dans les figures annexées. Ces figures représentent :
- les figures 1 a à 4c, différents états de la technique décrits dans ce qui précède ;
- les figures 5a et 5b, des courbes montrant les effets d'une implantation ionique sur les couches d'un transistor TBH selon l'invention ;
- les figures 6 et 7, un exemple de réalisation d'un transistor TBH selon l'invention ;
- la figure 8, une variante de réalisation d'un transistor TBH selon l'invention ;
- les figures 9a à 91, un exemple de procédé de réalisation selon l'invention d'un transistor TBH à collecteur haut.

De façon générale, le principe de la présente invention repose, d'une part, sur la sélectivité de gravure entre les deux matériaux constituant collecteur et base (cas du D-TBH) ou couche d'arrêt de gravure et base (cas du S-TBH), et d'autre part, sur la sensibilité différente de la conductivité des matériaux semiconducteurs soumis à une implantation ionique.

A titre d'exemple, l'invention est décrite dans le cadre des transistors bipolaires à double hétérojonction Ga_{0.5}In_{0.5}P/GaAs NPN en topologie Collecteur en haut. Cependant, elle s'applique par simple transposition à toute structure de transistor bipolaire à hétérojonction en topologie Collecteur en haut utilisant des hétérostructures Ga_{X}In₁₋ₓAs/Ga_{Y}In_{1-Y}P, que le matériau constituant le collecteur soit différent de celui de la base (cas du D-TBH) ou identique (aux caractéristiques de dopage près, dans le cas du S-TBH). Elle est aussi applicable à nombre de composants en cours de développement (SiC/GaN, AlGaN/GaN, AlGaN/InGaN...).

Comme nous l'avons décrit précédemment en figure 3, le profil de gravure du GalnP dépend fortement de l'orientation cristalline. Suivant la direction cristallographique selon laquelle est orienté l'électrode de collecteur, les flancs de la mésa collecteur présentent un angle rentrant ou sortant. On rappelle que la dimension latérale du dispositif est alors fixée par celle de la couche contact en GaAs n⁺, la gravure du GaInP se bloquant à l'interface des deux matériaux.

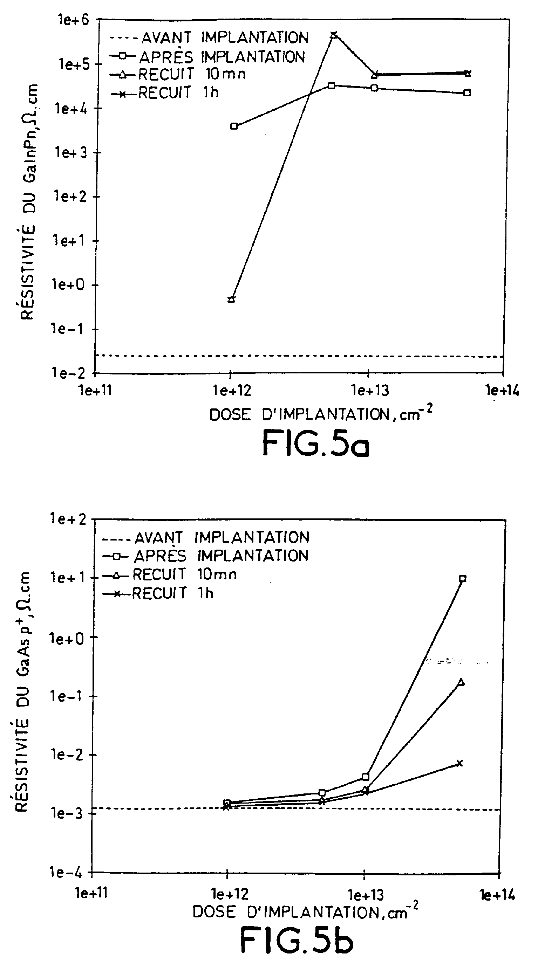

Les figures 5a et 5b montrent, à titre d'exemple, la différence de sensibilité de la conductivité électrique du GaInP dopé n et du GaAs dopé p⁺ respectivement, à une implantation de Bore à 200 keV à angle d'implantation nul en fonction de la dose d'ions introduits dans la structure. Cette évolution est suivie en fonction du temps de recuit à 416°C. Dans le cas du GaInP de type n, le matériau présente une résistivité électrique supérieure à 10⁵ Ω.cm pour une dose d'implantation de 5×10¹² cm⁻², alors que le GaAs de type p⁺ reste pratiquement insensible à l'implantation ionique jusqu'à des doses de 10¹³ cm⁻². Le comportement très différent de ces deux matériaux va nous permettre de rendre des couches de GaInP dopé n pratiquement isolantes tout en préservant à une couche de GaAs de type p⁺ (la base d'un TBH en l'occurrence) sa résistivité électrique initiale. Il est important de noter qu'un comportement similaire existe avec d'autres espèces atomiques, voire même entre deux couches de même matériau présentant des caractéristiques de dopage différents (GaAs de type p et n par exemple).

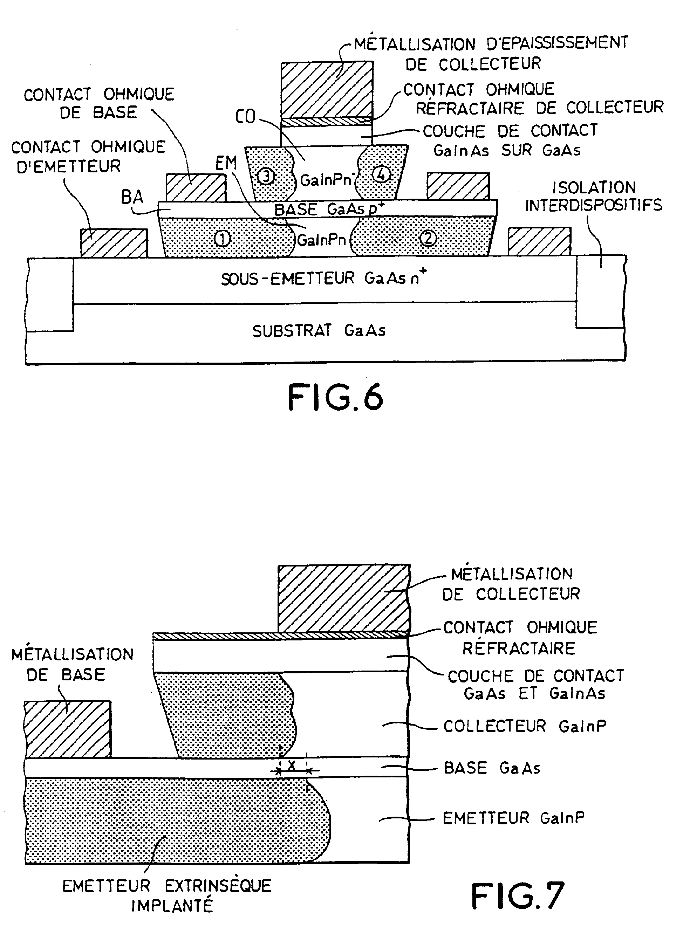

Grâce à ces propriétés physico-chimiques, il est possible de réaliser des composants présentant de part et d'autre de la base, une couche de semiconducteur rendue localement électriquement isolante par implantation ionique. La figure 6 montre la vue en coupe d'un D-TBH Collecteur en haut conçu à l'aide de la présente invention. Les surfaces des jonctions émetteur-base et base-collecteur sont alors définies lors de l'étape d'implantation ionique. On notera que se forme alors de part et d'autre de la mésa de collecteur, et ce, avant dépôt du contact de base, un caisson d'isolation équivalent à un sidewall, ce qui permet de réduire la présence de métallisation sur les flancs dénudés de la mésa de collecteur.

On voit donc que le dispositif de l'invention concerne un transistor TBH à collecteur en haut qui comporte notamment un empilement de couche d'émetteur EM, de couche de base BA et de couche de collecteur CO dans lequel le collecteur et l'émetteur sont auto-alignés par implantation et dans lequel :
- la couche d'émetteur EM comporte l'émetteur intrinsèque lui-même encadrée par du matériau isolant, de même la couche de collecteur CO comporte le collecteur encadré de matériau isolant ;
- la surface de la jonction base émetteur est inférieure à la surface de la jonction base collecteur ;
- le matériau de la base BA est tel qu'il présente une sensibilité de la conductivité électrique à une implantation ionique d'isolation plus faible que la sensibilité de la conductivité électrique du matériau de l'émetteur EM à la même implantation.

On va maintenant décrire de façon générale le procédé de réalisation selon l'invention d'un tel dispositif.

Le doigt (électrode) de collecteur est orienté selon la direction cristallographique < 0 1 1 > de manière à ce que, lors de l'étape de gravure, les flancs de la couche de collecteur rendue électriquement isolante présentent des angles rentrants. Une couche de contact en GaInAs au sommet de la structure épitaxiale permet de réaliser la prise de contact ohmique à l'aide d'un métal réfractaire tel que TiWSi, WN, ou TiW .... Afin d'obtenir une résistance de collecteur faible et de réaliser un masque d'implantation ionique efficace, une métallisation en Ti/Pt/Au, typiquement de 2 µm de large et d'une épaisseur de l'ordre d' 1µm, est déposée en surface. Les matériaux semiconducteurs protégés par ce masque métallique voient leur conductivité électrique initiale préservée. L'épaisseur de la métallisation en métal réfractaire est suffisamment fine pour permettre aux ions de la traverser sans perte majeure d'énergie. L'étape d'implantation se divise en deux opérations utilisant le même masque métallique. Une des deux opérations consiste à réaliser une implantation à haute énergie, faible dose (2.5×10¹² cm⁻²), à travers la totalité de la structure et qui peut être à angle d'implantation nul. L'énergie fournie aux ions implantés est calculée de manière à rendre isolante la couche d'émetteur en GaInP dans les zones situées sous la future base extrinsèque (caissons d'isolation 1 et 2) de manière à éliminer toute injection parasite d'électrons. L'autre opération consiste à définir la surface de la jonction base-collecteur par une implantation à plus faible énergie, faible dose et à travers la totalité de la structure. Les caissons d'isolations 3 et 4 sont ainsi créés localement dans la couche de collecteur en GaInP. Lors de ces étapes, la queue de distribution des ions traverse alors la base sans réellement la dégrader du fait de la faible sensibilité du matériau GaAs p⁺ à l'implantation. La faible augmentation de la résistivité du matériau de base est compensée lors d'une étape de recuit post-implantation (qui peut-être celle de recuit de contact ohmique allié par exemple) permettant de ramener la concentration de défauts cristallins au niveau le plus faible possible. Il est à noter que l'utilisation d'un matériau réfractaire offre la possibilité de recuire la structure à des températures élevées (si nécessaire) après définition de la mésa de collecteur.

On constate que plus l'énergie fournie aux ions implantés est importante, plus grande est leur profondeur de pénétration mais aussi plus étalée est la distribution finale des ions dans le volume (et par là même des défauts cristallins qu'ils engendrent). Ainsi la surface de la jonction émetteur-base (définie par l'implantation à haute énergie) va être plus faible que celle de la jonction base-collecteur (définie par une implantation à plus faible énergie). La figure 7 représente le profil que l'on va typiquement obtenir à l'issue de l'étape d'implantation ; x définie comme dans la figure 4 est de l'ordre de +0.2 µm. La présente invention nous permet donc d'éliminer l'accumulation des électrons dans la région de base extrinsèque et donc de se rapprocher des performances optimales autorisées par la structure du composant.

La mésa de collecteur doit être typiquement de l'ordre de 1 µm de chaque côté du ruban collecteur en Ti/Pt/Au afin de réaliser une collection efficace des électrons à la sortie de la base. La largeur de 1 µm permet de trouver un compromis efficace afin de réaliser des composants fonctionnant en hyperfréquence. La gain hyperfréquence tend, en effet, à chuter lorsqu'on éloigne le bord du ruban de contact ohmique de base de la zone active de d'émetteur puisqu'il y a alors augmentation de la résistance de base et la capacité base-collecteur. Il est possible de minimiser l'influence de cette dernière en gravant la couche de métal réfractaire, et en gravant ou isolant par implantation à forte dose la couche de contact en GaInAs et GaAs n⁺, au-dessus des caissons d'isolation de collecteur. Et en prenant certaines précautions particulières, le contact ohmique de base peut être réalisé en autoalignement par rapport à la mésa de collecteur.

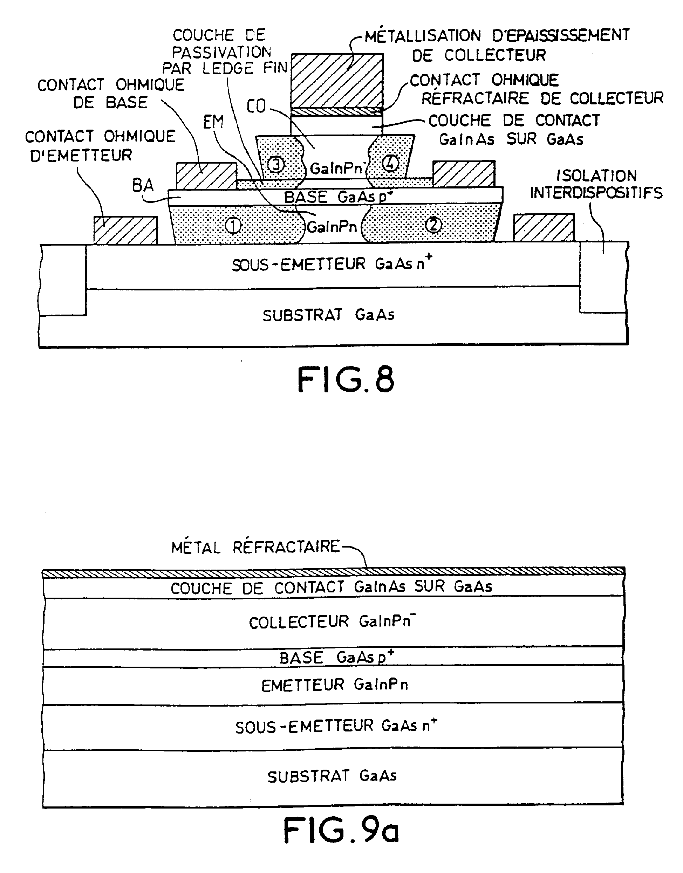

De plus, de telles dimensions de la mésa de collecteur restent compatibles avec le procédé de passivation à ledge épais décrit dans le brevet français n° 2 764 118). En effet, deux mécanismes au moins agissent sur la dérive des TBH en cours de fonctionnement. Il s'agit, d'une part, de l'évolution des recombinaisons dans la base neutre et, d'autre part, d'une augmentation des recombinaisons de surface à la surface libre de la base. La présence d'un matériau de grande bande interdite de part et d'autre du collecteur actif passivant la base extrinsèque est une solution efficace pour lutter contre ce second mécanisme. La couche de GaInP de collecteur rendue isolante limite donc les recombinaisons de surface au pied du doigt de collecteur. Elle passive ainsi à la fois la surface libre de la base extrinsèque et les flancs du collecteur. La présente invention peut aussi être associée à une fine couche de passivation par ledge plus classique telle que celle définie dans le brevet français n° 2 736 468. Un exemple de composant réalisé avec cette invention associée à un ledge mince classique est donné en figure 8. Le procédé de fabrication utilisé pour la présente invention est alors directement adaptable. La structure épitaxiale reste identique, seul l'enchaînement des étapes de fabrication est modifié.

En outre, cette invention peut utiliser un drain thermique permettant d'évacuer une partie des calories par le haut de la structure. Il peut être de type "nitrure" tel que celui breveté précédemment (brevet français n° 2 737 342) ou issu de toute autre méthode similaire.

On peut rappeler que dans le cas d'un S-TBH (Collecteur en GaAs n⁻), le contact ohmique réfractaire pourra être remplacé par un contact de type Schottky. Un contact métallique (Ti/Pt/Au par exemple) est alors directement déposé sur le collecteur en GaAs n⁻. La couche de contact (GalnAs n⁺ sur GaAs n⁺) est alors inutile. La structure épitaxiale est donc simplifiée. De plus, placé au plus proche de la zone de champs base-collecteur n- (là où est généré l'essentiel de la chaleur), le contact métallique, par sa haute conductivité thermique, préfigure un meilleur comportement thermique.

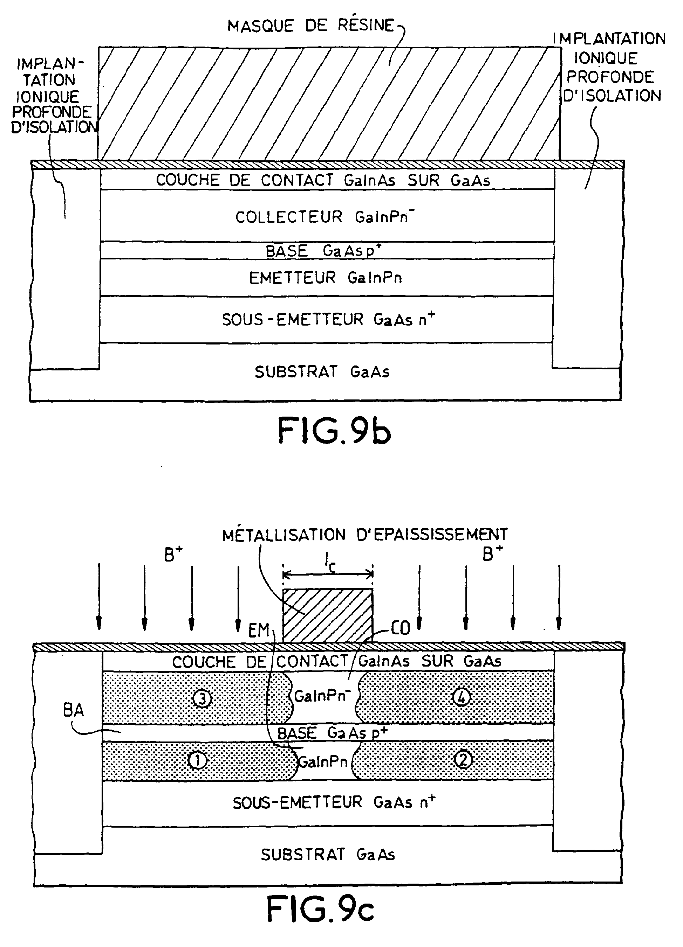

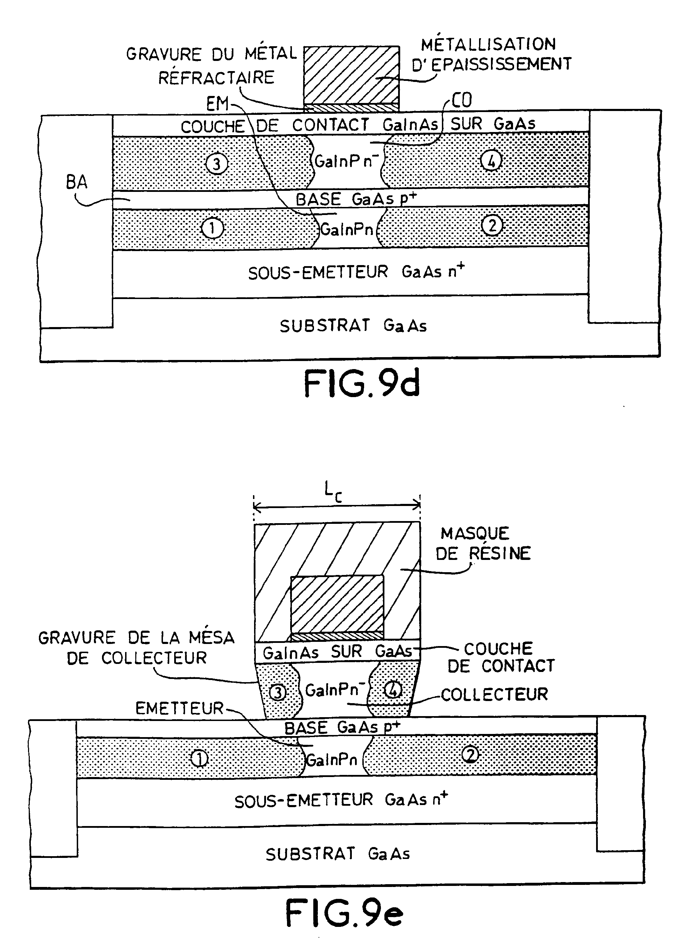

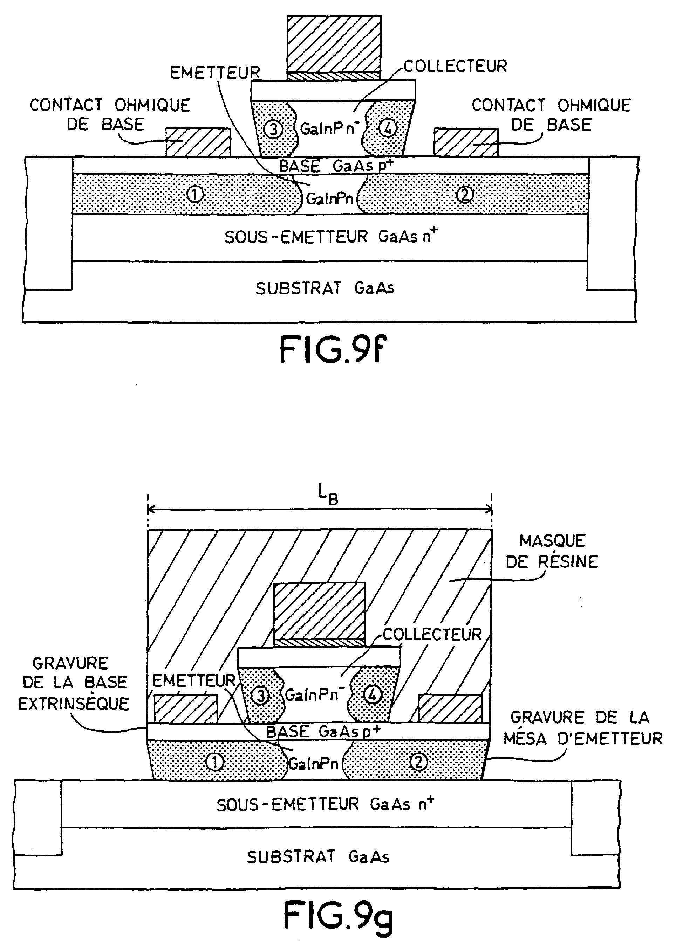

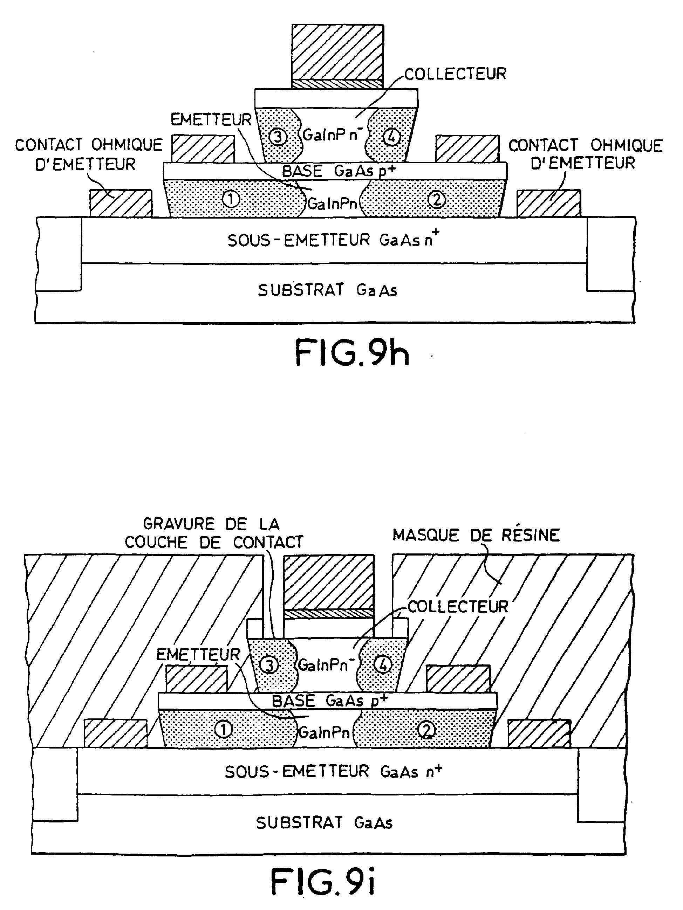

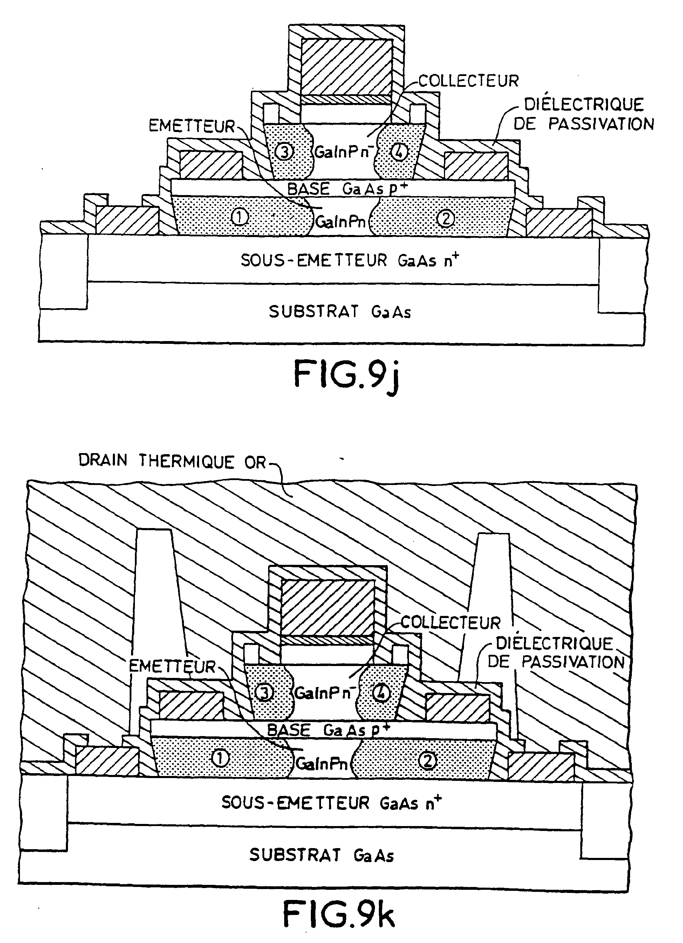

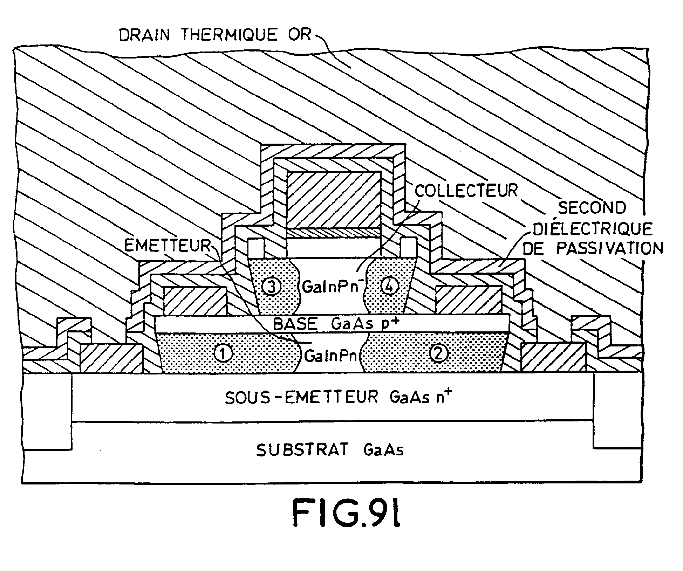

Les figures 9a à 91 décrivent plus en détails le procédé de fabrication selon l'invention permettant d'obtenir un transistor bipolaire à double hétérojonction en topologie collecteur en haut. La structure présentée ici est réalisée sans couche de passivation de type ledge mince mais avec un drain thermique supérieur. La description ne représente que la succession de procédés nécessaires à l'élaboration du composant élémentaire sans tenir compte des composants actifs ou passifs réalisés par ailleurs lors de la fabrication de la fonction totale à laquelle il faut aboutir.

### Figure 9a

A partir d'un substrat de GaAs semi-isolant, on réalise la croissance épitaxiale des couches suivantes :
- une couche de sous-émetteur en GaAs dopé n
- une couche d'émetteur en GaInP dopé n
- une couche de base en GaAs dopé p⁺
- une couche de collecteur en GaInP dopé n⁻
- une couche de contact en GaInAs dopé n⁺ sur GaAs dopé n⁺

Avantageusement, un espaceur fait d'une couche en GaAs dopé n associée ou non à une couche en GalnP dopé n, ou d'une couche graduelle de Ga_{X}In_{1-X}As_{Y}P_{1-Y} dopé n, peut être introduit entre base et collecteur (voire entre émetteur et base) pour minimiser le phénomène d'accumulation d'électrons dans le puits de potentiel de chacune des hétérojonctions. Cet espaceur n'est pas représenté ici.

Une couche de métal réfractaire est déposée ex-situ afin d'assurer le contact ohmique réfractaire de collecteur.

### Figure 9b

Après réalisation d'un masque de protection en résine, on procède à une étape d'implantation ionique profonde d'isolation électrique (H, He, B, O, F, ...) afin de diminuer les parasites du composant et réaliser l'isolation inter-composants.

### Figure 9c

On procède alors au dépôt d'une métallisation d'épaississement du contact ohmique de collecteur de largeur l_{C} par "Lift-off' (Ti/Au, Ti/Pt/Au ...) puis à l'implantation ionique sélective au bore à haute énergie, de manière à définir les caissons d'isolation ① et ② dans les zones d'émetteur extrinsèque. Cette étape d'implantation conduit de manière inhérente à la définition de la forme de 'émetteur intrinsèque et donc à celle de la surface de la jonction émetteur-base.

Toujours avec le masque de protection fait de la métallisation d'épaississement du contact ohmique, on implante la structure au bore mais à plus faible énergie de manière à définir les caissons d'isolation ③ et ④ dans les zones de collecteur extrinsèque. Cette étape d'implantation conduit de manière inhérente à la définition de la forme du collecteur intrinsèque et donc à celle de la surface de la jonction base-collecteur.

En raison du fait que l'implantation au bore dans l'émetteur se fait à haute énergie et que l'implantation dans le collecteur se fait à moindre énergie, la surface implantée au niveau de la jonction émetteur-base est plus importante que celle de la jonction collecteur-base. On a donc une surface de la jonction base/collecteur supérieure à la surface de la jonction base/émetteur.

### Figure 9d

La métallisation d'épaississement du contact de collecteur est encore utilisée comme masque de protection. On effectue alors une gravure sèche du métal réfractaire par gravure ionique réactive à base de SF₆ par exemple.

### Figure 9e

On définit alors la mésa de collecteur. Pour cela, on réalise un masque de protection de résine de largeur L_{C}>l_{C}. On procède à la gravure de la couche de contact de GalnAs par gravure humide à base d'acide citrique, puis à celle de la couche de contact en GaAs par gravure ionique réactive (RIE) chlorée telle que SiCl₄ ou par gravure chimique à l'aide d'acide citrique par exemple et de la couche de collecteur en GaInP implanté au bore en gravure chimique à base d'acide chlorhydrique.

### Figure 9f

On dépose les contacts ohmiques de base par technique de "Lift-off". Le film métallique utilisé peut être fait d'un alliage de Ti/Pt/Au ou de Mo/Au par exemple.

### Figure 9g

On réalise un masque de protection de résine de largeur L_{B}>L_{C} puis on procède à la gravure de la mésa de base par voie sèche (gravure ionique réactive chlorée) ou mixte (RIE puis chimique) suivi de la gravure de la couche d'émetteur en GaInP implanté au bore en gravure chimique à base d'acide chlorhydrique. La gravure du GaInP se bloque à l'interface GaAs/GalnP. La dimension latérale de la mésa de base fixe donc celle de la mésa d'émetteur.

### Figure 9h

Les contacts ohmiques d'émetteur sont déposés en utilisant la technique du "Lift-off".

### Figure 9i

On dépose alors une résine protégeant la totalité de la surface du composant. On procède à l'ouverture de cette résine en surface de la couche de contact en GalnAs/GaAs.

Les zones de cette couche de contact ainsi mises à nues et non protégées par la métallisation d'épaississement de collecteur, sont alors gravées de manière à minimiser la capacité base-collecteur. On procède donc à la gravure de la couche de contact de GalnAs par gravure humide à base d'acide citrique, puis à celle de la couche de contact en GaAs par gravure ionique réactive (RIE) chlorée telle que SiCl₄ ou par gravure chimique à l'aide d'acide citrique par exemple.

On procède au dépôt d'une couche de diélectrique de passivation protégeant la totalité de la surface du composant (figure 9j).

### Figures 9k et 9l

On peut alors réaliser un drain thermique reposant sur le haut de la structure après passivation du composant tel que cela est décrit dans le brevet français n° 2 737 342.

Un tel drain thermique peut être basé sur une technique piliers/tabliers telle que représenté sur la figure 9j. Avantageusement, l'air présente sous le tablier peut être remplacé par un diélectrique possédant de bonnes propriétés de planarisation comme le benzocyclobutène (BCB) par exemple. Ce qui permet, du point de vue de ses propriétés mécaniques, de renforcer la structure en vue notamment d'opérations de report.

D'autres solutions sont envisageables pour la réalisation du drain thermique. La figure 9k présente la vue en coupe d'un TBH utilisant un drain thermique de type "double nitrure". Avec cette technique, le drain thermique recouvre la totalité du composant et n'utilise pas de ponts (à air, à BCB, ...). L'étape de réalisation des piliers est supprimée, l'évacuation des calories, donc le comportement thermique du composant, sont optimales. Mais une faible dégradation de la valeur de certains éléments parasites est à prévoir (augmentation de la capacité parasite de collecteur par exemple), dégradation pouvant influencer légèrement le comportement hyperfréquence du composant.

## Revendications

1. Transistor bipolaire à hétérojonction à collecteur en haut comprenant notamment empilées sur un substrat :
- une couche d'émetteur (EM)
- une couche de base (BA)
- une couche de collecteur (CO)
- le matériau de la couche de base présente une sensibilité de la conductivité électrique en fonction de la dose d'ions introduits lors d'une implantation ionique plus faible que la sensibilité de la conductivité électrique du matériau de couche d'émetteur en fonction de la dose d'ions introduits lors de la même implantation ionique;
**caractérisé en ce que** :
- la surface de la jonction base-émetteur est de dimensions inférieures à la surface de la jonction base-collecteur.

2. Transistor bipolaire à hétérojonction selon la revendication 1, **caractérisé en ce que** la couche d'émetteur et la couche collecteur comportent chacune une zone intrinsèque encadrée par du matériau isolant.

3. Transistor bipolaire à hétérojonction selon la revendication 2. **caractérisé en ce que** la largeur de chaque élément isolant électrique de collecteur est voisine du micron, la largeur de la mésa étant voisine de deux microns.

4. Transistor bipolaire à hétérojonction selon la revendication 2, **caractérisé en ce que** le collecteur est constituée de Ga_{X}In_{1-X}P dopé n, la base de Ga_{Y}In_{1-Y}As dopé p, l'émetteur de Ga_{X}In_{1-X}P dopé n, et tous les éléments isolants (d'émetteur comme de collecteur) de Ga_{X}In_{1-X}P contenant du Bore.

5. Transistor bipolaire à hétérojonction selon la revendication 2, **caractérisé en ce que** le collecteur est constituée de Ga_{Y}In_{1-Y}As dopé n, la base de Ga_{Y}In_{1-Y}As dopé p, l'émetteur de Ga_{X}In_{1-X}P dopé n, les éléments isolants de collecteur de Ga_{Y}In_{1-Y}As contenant du Bore, et les éléments isolants d'émetteur de Ga_{X}In_{1-X}P contenant du Bore.

6. Transistor bipolaire à hétérojonction selon la revendication 2, **caractérisé en ce qu'**il comprend entre la couche d'émetteur et celle de base, et/ou, entre la couche de base et celle de collecteur, une couche d'espaceur formée d'une succession de couche de Ga_{X}In_{1-X}P et de Ga_{Y}In_{1-Y}As dopés n.

7. Transistor bipolaire à hétérojonction selon l'une des revendications 1 ou 2, **caractérisé en ce que** le collecteur comprend en surface une couche de contact ohmique en métal réfractaire de type TiWSi, WN, TiW.

8. Transistor bipolaire à hétérojonction selon l'une des revendications 1 ou 6, **caractérisé en ce qu'**il comprend une couche mince semiconductrice de passivation entre la couche de base et la couche de collecteur ou entre la couche d'espaceur et la couche de collecteur.

9. Transistor bipolaire à hétérojonction selon l'une des revendications précédentes, **caractérisé en ce qu'**il comprend en outre une couche de passivation recouvrant l'ensemble du relief du transistor.

10. Transistor bipolaire à hétérojonction selon la revendication 9, **caractérisé en ce qu'**il comprend un drain thermique en forme de pont reposant d'une part sur une partie du relief du transistor, d'autre part sur le substrat.

11. Transistor bipolaire à hétérojonction selon la revendication 9, **caractérisé en ce qu'**il comporte un drain qui est en contact avec la totalité du composant et qui est couplé thermiquement avec le substrat

12. Procédé de réalisation, d'un transistor bipolaire à hétérojonction à collecteur en haut selon la revendication 1, comprenant la croissance épitaxiale de couches semiconductrices sur un substrat semiconducteur :
- une couche d'émetteur
- une couche de base
- une couche de collecteur
**caractérisé en ce que** :
- les matériaux de la couche de base et de la couche d'émetteur sont choisis tels que le matériau de la couche de base présente une sensibilité de la conductivité électrique en fonction de la dose d'ions introduits lors d'une implantation ionique plus faible que la sensibilité de la conductivité électrique de la couche d'émetteur en fonction de la dose d'ions introduits lors de la même implantation ionique;
- et **en ce qu'**il comporte les étapes supplémentaires suivantes : réalisation d'un masque sur la couche de collecteur et de largeur (le) correspondant à la largeur du collecteur à obtenir, puis réalisation d'une première implantation ionique permettant de rendre isolant le matériau de la couche d'émetteur de part et d'autre de l'émetteur à obtenir, puis réalisation d'une deuxième implantation ionique d'énergie inférieure à la première implantation ionique pour rendre isolant le matériau de la couche de collecteur de part et d'autre du collecteur à obtenir.

13. Procédé de réalisation d'un transistor bipolaire à hétérojonction selon la revendication 12, **caractérisé en ce que** le transistor est à base de matériaux 111-V et comprend la croissance épitaxiale de couches semiconductrices dont une couche dopée de type p (ou n) et constitutive de la base est comprise entre deux couches de type n (ou p) et constitutives de l'émetteur et du collecteur, **caractérisé à ce qu**'il comprend en outre :
- l'implantation ionique à travers un masque de largeur l_{c} de la couche dite supérieure située au-dessus de la base de manière à définir des éléments électriquement isolants de part et d'autre d'un élément semiconducteur dopé de largeur L_{BC},
- l'implantation ionique à travers le même masque de largeur l_{C} de la couche dite inférieure située en dessous de la base de manière à définir des éléments électriquement isolants de part et d'autre d'un élément semiconducteur dopé de largeur L_{EB} inférieure à L_{BC},
- la gravure à travers un masque de largeur L_{C}>l_{C} de la couche supérieure en vue de réaliser une mésa qui définit la géométrie des caissons d'isolation créés précédemment par implantation ionique.
- la gravure à travers un masque de largeur supérieure à L_{C} de la couche inférieure en vue de réaliser une mésa qui définit la géométrie des caissons d'isolation créés précédemment par implantation ionique.

14. Procédé de réalisation d'un transistor bipolaire à hétérojonction selon la revendication 13, **caractérisé en ce que** les couches dite supérieure et de base ont des comportements différents vis-à-vis de l'implantation ionique.

15. Procédé de réalisation d'un transistor bipolaire à hétérojonction selon la revendication 14. **caractérisé en ce que** la couche dite inférieure est en Ga_{X}In_{1-X}P dopé n, la base en Ga_{Y}In_{1-Y}As dopé p, et la couche dite supérieure en Ga_{X}In_{1-X}P dopé n ou en Ga_{Y}In_{1-Y}As dopé n.

16. Procédé de réalisation d'un transistor bipolaire à hétérojonction selon l'une des revendications 13 à 15, **caractérisé en ce que** le masque de largeur l_{C} est en métal de type Ti/Au ou Ti/Pt/Au.

17. Procédé de réalisation d'un transistor bipolaire à hétérojonction selon l'une des revendications 13 à 15, **caractérisé en ce que** le masque de largeur l_{C} est en résine.

## Claims

1. A collector-up heterojunction bipolar transitor particularly comprising, stacked on a substrate:
- an emitter layer (EM);
- a base layer (BA) ;
- a collector layer (CO);
- the material of the base layer exhibits a sensitivity of the electrical conductivity as a function of the dose of ions introduced during an ion implantation which is lower than the sensitivity of the electrical conductivity of the material of the emitter layer as a function of the dose of ions introduced during the same ion implantation,
**characterized in that**:
- the surface area of the base-emitter junction is of smaller dimensions than the surface area of the base-collector junction.

2. Heterojunction bipolar transistor according to Claim 1, **characterized in that** the emitter layer and the collector layer each include an intrinsic area flanked by insulating material.

3. Heterojunction bipolar transistor according to Claim 2, **characterized in that** the width of each collector electrical isolating element is close to one micron, the width of the mesa being close to two microns.

4. Heterojunction bipolar transistor according to Claim 2, **characterized in that** the collector consists of n-doped GaₓIn₁₋ₓP, the base of p-doped Ga_{y}In_{1-y}As, the emitter of n-doped GaₓIn₁₋ₓP, and all the isolating elements (of emitter as well as of collector) of GaₓIn₁₋ₓP containing boron.

5. Heterojunction bipolar transistor according to Claim 2, **characterized in that** the collector consists of n-doped Ga_{y}In_{1-y}As, the base of p-doped Ga_{y}In_{1-y}As, the emitter of n-doped GaₓIn₁₋ₓP, the collector isolating elements of Ga_{y}In_{1-y}As containing boron, and the emitter isolating elements of GaₓIn₁₋ₓP containing boron.

6. Heterojunction bipolar transistor according to Claim 2, **characterized in that** it comprises, between the emitter layer and that of the base, and/or, between the base layer and that of the collector, a spacer layer formed from a succession of layer of n-doped GaₓIn₁₋ₓP and of Ga_{y}In_{1-y}As.

7. Heterojunction bipolar transistor according to either of Claims 1 and 2, **characterized in that** the collector comprises, on its surface, an ohmic contact layer made of refractory metal of TiWSi, WN or TiW type.

8. Heterojunction bipolar transistor according to either of Claims 1 and 6, **characterized in that** it comprises a semiconducting thin film for passivation between the base layer and the collector layer or between the spacer layer and the collector layer.

9. Heterojunction bipolar transistor according to one of the preceding claims, **characterized in that** it further comprises a passivation layer covering the whole of the relief of the transistor.

10. Heterojunction bipolar transistor according to Claim 9, **characterized in that** it comprises a heat sink in bridge shape resting, on the one hand, on a part of the relief of the transistor and, on the other hand, on the substrate.

11. Heterojunction bipolar transistor according to Claim 9, **characterized in that** it includes a sink which is in contact with the whole of the component and which is thermally coupled with the substrate.

12. Method of manufacturing a collector-up heterojunction bipolar transistor according to Claim 1, comprising the epitaxial growth of semiconducting layers on a semiconductor substrate:
- an emitter layer;
- a base layer;
- a collector layer;
**characterized in that**:
- the materials of the base layer and of the emitter layer are chosen such that the material of the base layer exhibits a sensitivity of the electrical conductivity as a function of the dose of ions introduced during an ion implantation which is lower than the sensitivity of the electrical conductivity of the emitter layer as a function of the dose of ions introduced during the same ion implantation;
and **in that** it includes the following additional stages:
- production of a mask on the collector layer, having a width (lc) corresponding to the width of the collector to be obtained, then carrying out a first ion implantation making it possible to render the material of the emitter layer insulating on either side of the emitter to be obtained, then carrying out a second ion implantation using energy which is lower than the first ion implantation, so as to render the material of the collector layer insulating on either side of the collector to be obtained.

13. Method of producing a heterojunction bipolar transistor according to Claim 12, **characterized in that** the transistor is based on III-V materials and comprises the epitaxial growth of semiconductor layers in which a layer doped p-type (or n-type) and constituting the base is comprised between two layers of n type (or p type) and constituting the emitter and the collector, **characterized in that** it further comprises:
- ion implantation through a mask having width lc of the layer known as upper layer situated above the base in such a way as to define electrically isolating elements on either side of a doped semiconductor element having width L_{BC};
- ion implantation through the same mask having width lc of the layer known as lower layer situated below the base in such a way as to define electrically isolating elements on either side of a doped semiconductor element having width LEB which is less than LBC;
- etching, through a mask having width Lc > lc of the upper layer with a view to producing a mesa which defines the geometry of the isolating wells created previously by ion implantation and;
- etching, through a mask having width greater than Lc of the lower layer with a view to producing a mesa which defines the geometry of the isolating wells created previously by ion implantation.

14. Method of producing a heterojunction bipolar transistor according to Claim 13, **characterized in that** the layers known as upper and base layer have different behaviors as regards the ion implantation.

15. Method of producing a heterojunction bipolar transistor according to Claim 14, **characterized in that** the layer known as lower layer is made of n-doped GaₓIn₁₋ₓP, the base of p-doped Ga_{y}In_{1-y}As, and the layer known as upper layer of n-doped GaₓIn₁₋ₓP or of n-doped Ga_{y}In_{1-y}As.

16. Method of producing a heterojunction bipolar transistor according to one of Claims 13 to 15, **characterized in that** the mask having width l_{c} is made of metal of the Ti/Au or Ti/Pt/Au type.

17. Method of producing a heterojunction bipolar transistor according to one of Claims 13 to 15, **characterized in that** the mask having width l_{c} is made of a resist.

## Patentansprüche

1. Bipolartransistor mit Heteroübergang mit oben liegendem Kollektor, der insbesondere auf einem Substrat gestapelt aufweist:
- eine Emitterschicht (EM)
- eine Basisschicht (BA)
- eine Kollektorschicht (CO)
- wobei der Werkstoff der Basisschicht eine Empfindlichkeit der elektrischen Leitfähigkeit in Abhängigkeit von der bei einer Ionenimplantation eingeführten Ionendosis aufweist, die schwächer ist als die Empfindlichkeit der elektrischen Leitfähigkeit des Werkstoffs der Emitterschicht in Abhängigkeit von der bei der gleichen Ionenimplantation eingeführten Ionendosis;
**dadurch gekennzeichnet, dass**:
- die Fläche des Basis-Emitter-Übergangs kleinere Abmessungen hat als die Fläche des Basis-Kollektor-Übergangs.

2. Bipolartransistor mit Heteroübergang nach Anspruch 1, **dadurch gekennzeichnet, dass** die Emitterschicht und die Kollektorschicht je eine eigene Zone aufweisen, die von isolierendem Werkstoff umrahmt ist.

3. Bipolartransistor mit Heteroübergang nach Anspruch 2, **dadurch gekennzeichnet, dass** die Breite jedes elektrisch isolierenden Elements des Kollektors nahe einem Mikron ist, während die Breite des ebenen Bereichs nahe zwei Mikron ist.

4. Bipolartransistor mit Heteroübergang nach Anspruch 2, **dadurch gekennzeichnet, dass** der Kollektor aus n-dotiertem GaxIn1-xP, die Basis aus p-dotiertem GayInl-yAs, der Emitter aus n-dotiertem GaxIn1-xP besteht, und alle isolierenden Elemente (des Emitters wie des Kollektors) aus Bor enthaltendem GaxIn1-xP bestehen.

5. Bipolartransistor mit Heteroübergang nach Anspruch 2, **dadurch gekennzeichnet, dass** der Kollektor aus n-dotiertem GayIn1-yAs, die Basis aus p-dotiertem GayIn1-yAs, der Emitter aus n-dotiertem GaxIn1-xP, die isolierenden Elemente des Kollektors aus Bor enthaltendem GayIn1-yAs und die isolierenden Elemente des Emitters aus Bor enthaltendem GaxIn1-xP bestehen.

6. Bipolartransistor mit Heteroübergang nach Anspruch 2, **dadurch gekennzeichnet, dass** er zwischen der Emitterschicht und der Basisschicht, und/oder zwischen der Basisschicht und der Kollektorschicht eine Abstandshalterschicht aufweist, die von einer Schichtfolge von n-dotiertem GaxIn1-xP und n-dotiertem GayIn1-yAs gebildet wird.

7. Bipolartransistor mit Heteroübergang nach einem der Ansprüche 1 oder 2, **dadurch gekennzeichnet, dass** der Kollektor an der Oberfläche eine ohmsche Kontaktschicht aus feuerfestem Metall vom Typ TiWSi, WN, TiW aufweist.

8. Bipolartransistor mit Heteroübergang nach einem der Ansprüche 1 oder 6, **dadurch gekennzeichnet, dass** er eine dünne Passivierungs-Halbleiterschicht zwischen der Basisschicht und der Kollektorschicht oder zwischen der Abstandshalterschicht und der Kollektorschicht aufweist.

9. Bipolartransistor mit Heteroübergang nach einem der vorhergehenden Ansprüche, **dadurch gekennzeichnet, dass** er außerdem eine Passivierungsschicht aufweist, die das ganze Relief des Transistors bedeckt.

10. Bipolartransistor mit Heteroübergang nach Anspruch 9, **dadurch gekennzeichnet, dass** er einen thermischen Drain in Form einer Brücke aufweist, die einerseits auf einem Teil des Reliefs des Transistors und andererseits auf dem Substrat ruht.

11. Bipolartransistor mit Heteroübergang nach Anspruch 9, **dadurch gekennzeichnet, dass** er einen Drain aufweist, der mit der Gesamtheit des Bauteils in Kontakt ist und der thermisch mit dem Substrat gekoppelt ist.

12. Verfahren zur Herstellung eines Bipolartransistors mit Heteroübergang mit oben liegendem Kollektor nach Anspruch 1, das das epitaxiale Wachsen von Halbleiterschichten auf einem Halbleitersubstrat aufweist:
- einer Emitterschicht
- einer Basisschicht
- einer Kollektorschicht
**dadurch gekennzeichnet, dass**:
- die Werkstoffe der Basisschicht und der Emitterschicht so gewählt werden, dass der Werkstoff der Basisschicht eine Empfindlichkeit der elektrischen Leitfähigkeit in Abhängigkeit von der bei einer Ionenimplantation eingeführten Ionendosis aufweist, die schwächer ist als die Empfindlichkeit der elektrischen Leitfähigkeit der Emitterschicht in Abhängigkeit von der bei der gleichen Ionenimplantation eingeführten Ionendosis;
- und dass es die folgenden zusätzlichen Schritte aufweist: Herstellung einer Maske auf der Kollektorschicht mit einer Breite (lc) entsprechend der Breite des zu erhaltenden Kollektors, dann Durchführung einer ersten Ionenimplantation, die es ermöglicht, den Werkstoff der Emitterschicht zu beiden Seiten des zu erhaltenden Emitters isolierend zu machen, dann Durchführung einer zweiten Ionenimplantation mit einer geringeren Energie als bei der ersten Ionenimplantation, um den Werkstoff der Kollektorschicht zu beiden Seiten des zu erhaltenden Kollektors isolierend zu machen.

13. Verfahren zur Herstellung eines Bipolartransistors mit Heteroübergang nach Anspruch 12, **dadurch gekennzeichnet, dass** der Transistor auf der Basis von Werkstoffen III-V ist und das epitaxiale Wachsen von Halbleiterschichten aufweist, darunter eine dotierte Schicht vom Typ p (oder n), die die Basis bildet und zwischen zwei Schichten vom Typ n (oder p) enthalten ist, die den Emitter und den Kollektor bilden, **dadurch gekennzeichnet, dass** es weiter aufweist:
- die Ionenimplantation durch eine Maske der Breite lc der so genannten oberen Schicht hindurch, die sich über der Basis befindet, um elektrisch isolierende Elemente zu beiden Seiten eines dotierten Halbleiterelements der Breite LBC zu definieren,
- die Ionenimplantation durch die gleiche Maske einer Breite lc der so genannten unteren Schicht hindurch, die sich unter der Basis befindet, um elektrisch isolierende Elemente zu beiden Seiten eines dotierten Halbleiterelements einer Breite L_{EB} geringer als L_{BC} zu definieren,
- das Ätzen durch eine Maske einer Breite LC>IC der oberen Schicht hindurch, um einen ebenen Bereich herzustellen, der die Geometrie der Isoliergehäuse definiert, die vorher durch Ionenimplantation erzeugt wurden,
- das Ätzen durch eine obere Maske einer Breite größer als LC der unteren Schicht hindurch, um einen ebenen Bereich herzustellen, der die Geometrie der Isoliergehäuse definiert, die vorher durch Ionenimplantation erzeugt wurden.

14. Verfahren zur Herstellung eines Bipolartransistors mit Heteroübergang nach Anspruch 13, **dadurch gekennzeichnet, dass** die so genannten obere Schicht und Basisschicht unterschiedliche Verhaltensweisen gegenüber der Ionenimplantation haben.

15. Verfahren zur Herstellung eines Bipolartransistors mit Heteroübergang nach Anspruch 14, **dadurch gekennzeichnet, dass** die so genannte untere Schicht aus n-dotiertem GaxIn1-xP, die Basis aus p-dotiertem GayIn1-yAs und die so genannte obere Schicht aus n-dotiertem GaxIn1-xP oder aus n-dotiertem GayIn1-yAs ist.

16. Verfahren zur Herstellung eines Bipolartransistors mit Heteroübergang nach einem der Ansprüche 13 bis 15, **dadurch gekennzeichnet, dass** die Maske der Breite lc aus einem Metall vom Typ Ti/Au oder Ti/Pt/Au ist.

17. Verfahren zur Herstellung eines Bipolartransistors mit Heteroübergang nach einem der Ansprüche 13 bis 15, **dadurch gekennzeichnet, dass** die Maske der Breite l_{c} aus Harz ist.
